Europäisches Patentamt

European Patent Office

Office européen des brevets

(19)

(11) EP 0 446 090 B1

(12) FASCICULE DE BREVET EUROPEEN

(45) Date de publication et mention
de la délivrance du brevet:
**27.03.1996 Bulletin 1996/13**

(51) Int Cl.[6]: **H03K 3/64**

(21) Numéro de dépôt: **91400431.2**

(22) Date de dépôt: **19.02.1991**

(54) **Dispositif numérique de génération d'une trame d'impulsions et son application à la génération de trames d'impulsions de réveil de modules électroniques**

Digitale Vorrichtung zum Erzeugen einer Impulskette und ihre Anwendung zum Erzeugen von Erwachungsimpulsketten für elektronische Module

Digital device for generating a train of pulses and its application for generating wake-up pulse trains for electronic modules

(84) Etats contractants désignés:
**DE ES GB IT**

(30) Priorité: **01.03.1990 FR 9002571**

(43) Date de publication de la demande:
**11.09.1991 Bulletin 1991/37**

(73) Titulaire: **REGIE NATIONALE DES USINES RENAULT S.A.**
**F-92109 Boulogne Billancourt (FR)**

(72) Inventeurs:
 • **Millereau, Jean-Luc**
 **F-78400 Chatou (FR)**
 • **Lenoir, Dominique**
 **F-92360 Meudon-la-Foret (FR)**

(74) Mandataire: **Ernst-Schonberg, Michel et al**
**REGIE NATIONALE DES USINES RENAULT**
**Service 02 67**
**8-10, Avenue Emile Zola**
**F-92109 Boulogne-Billancourt (FR)**

(56) Documents cités:
**EP-A- 0 327 456**

 • **INSTRUMENTS AND EXPERIMENTAL TECHNIQUES, vol. 22, no. 2, partie 1, mars/avril 1979, pages 441-443; V.E. BARON et al.: "Rectangular pulse generator"**
 • **NEW ELECTRONICS, vol. 18, no. 2, 22 janvier 1985, page 28; A.J. CHAMBERLAIN:"Pulse train generator"**
 • **WIRELESS WORLD, vol. 87, no. 1541, février 1981, page 63; J. WILLIAMS: "Ringing-tone generator"**
 • **ELECTRONICS, vol. 51, no. 24, 23 novembre 1978, pages 147,149; R. DOUGHERTY: "One-button controller issues step, run, and halt commands"**

## Description

La présente invention est relative à un dispositif de génération d'une trame d'impulsions électriques et, plus particulièrement, à un tel dispositif numérique conçu pour déclencher le "réveil" d'une pluralité de modules électroniques embarqués dans un véhicule automobile.

Le dispositif suivant l'invention est conçu pour permettre la génération, à la suite de la fermeture d'un contact électrique, d'une trame d'impulsions constituée de n salves de m impulsions, ces salves se répétant avec une période prédéterminée.

De telles trames d'impulsions trouvent application notamment dans le dispositif décrit dans la demande de brevet français déposée ce jour par la demanderesse et intitulée "Dispositif de commande de l'alimentation électrique d'une pluralité de modules électroniques ". Le dispositif de commande décrit dans cette demande de brevet est sensible à l'émission d'une telle trame d'impulsions par un des modules pour commander le "réveil" de l'ensemble des modules alors que l'alimentation de ceux-ci était au préalable réglée pour un état de "veille". Les modules sont interconnectés dans un réseau de communications multiplex, embarqué dans un véhicule automobile. Dans cette application, le dispositif de commande identifie le module émetteur à partir du nombre d'impulsions m contenues dans une salve. La salve est répétée n fois pour permettre au dispositif de s'assurer, par des comparaisons des nombres d'impulsions contenues dans des salves successives, que les impulsions comptées sont bien originaires d'un module, de manière à éviter de prendre en compte des impulsions parasites induites sur un bus de données interconnectant les modules.

On sait que l'environnement d'un véhicule automobile est particulièrement sévère pour l'électronique embarquée du fait des variations de température auxquelles le véhicule est soumis et des perturbations électriques et électromagnétiques présentes dans cet environnement. Des contraintes de prix ne permettent pas non plus d'utiliser des composants à très faible tolérance de fabrication. Une réalisation d'un dispositif de génération de la trame d'impulsions décrite ci-dessus, en technologie analogique et destinée à un tel environnement, serait fortement pénalisée par toutes les dispositions qu'il faudrait adopter pour prendre en compte toutes ces contraintes.

La présente invention a donc pour but de réaliser un dispositif de génération d'une trame d'impulsion constitué de n salves de m impulsions, qui soit utilisable notamment dans un environnement automobile et qui ne présente pas ces inconvénients.

La présente invention a aussi pour but de réaliser un tel dispositif conçu pour permettre de programmer simplement et de manière peu coûteuse, le nombre m d'impulsions contenues dans une salve de la trame.

La présente invention a encore pour but de réaliser un tel dispositif conçu pour être intégré à un module électronique formant partie d'un ensemble de tels modules embarqués dans un véhicule automobile et interconnectés dans un réseau local de communications, le dispositif servant alors à engendrer des trames de signaux propres à réveiller l'ensemble des modules, alors que ceux-ci se trouvaient préalablement dans un état de veille.

On atteint ces buts de l'invention, ainsi que d'autres qui apparaîtront dans la suite de la présente description, avec un dispositif numérique de génération d'une trame d'impulsions électriques constituée de n salves de m impulsions, ces salves se répétant avec une période (T) prédéterminée, ce dispositif étant remarquable en ce qu'il comprend :

a) un compteur binaire,
b) un premier compteur à décades,
c) un générateur de signaux d'horloge pour alimenter simultanément ces deux compteurs,
d) un deuxième compteur à décades dont l'entrée d'horloge est connectée à une sortie prédéterminée du premier compteur à décades,
e) un moyen de formation d'un signal de déclenchement de ces compteurs et du générateur de signaux d'horloge, la sortie de rang m du deuxième compteur à décades commandant des entrées de validation des premier et deuxième compteurs à décades, une sortie prédéterminée du compteur binaire délivrant un signal à la fréquence de répétition (1/T) des salves commandant des entrées de remise à zéro des premier et deuxième compteurs à décades, une autre sortie prédéterminée du compteur binaire délivrant un signal présentant une demi-période comprise entre (n-1)T et nT et commandant le blocage du compteur binaire, ce par quoi une trame de n salves de m impulsions apparaît sur une sortie du premier compteur à décades, à la suite de l'émission d'un signal de déclenchement.

Le dispositif comprend en outre des moyens de commande des entrées de remise à zéro des compteurs et des moyens pour échantillonner la durée du signal de déclenchement, ces moyens d'échantillonnage commandant le blocage du compteur binaire par l'intermédiaire des moyens de commande quand la durée du signal est inférieure à une durée prédéterminée.

Les moyens de commande sont constitués par une première bascule type D et les moyens pour échantillonner la durée du signal de déclenchement comprennent une deuxième bascule type D commandant l'entrée d'horloge de la première bascule dont l'entrée D est commandée par le signal de déclenchement, l'entrée d'horloge de la deuxième bascule étant commandée par une sortie du premier compteur à décades qui émet une impulsion sur l'entrée d'horloge de la deuxième bascule au bout d'un temps égal à la durée prédéterminée minimum du signal de déclenchement nécessaire à la prise en compte de celui-ci.

Suivant un mode de réalisation avantageux du dispositif selon l'invention, celui-ci comprend des moyens de connexion pour sélectionner la sortie de rang $m$ du deuxième compteur à décades qui commande les entrées de validation des deux compteurs à décades.

D'autres caractéristiques et avantages du dispositif suivant la présente invention apparaîtront à la lecture de la description qui va suivre et à l'examen du dessin annexé dans lequel :

- la figure 1 est un schéma de câblage du dispositif selon l'invention, et
- les figures 2 à 5 sont des ensembles de chronogrammes utiles à la compréhension du fonctionnement du dispositif selon l'invention.

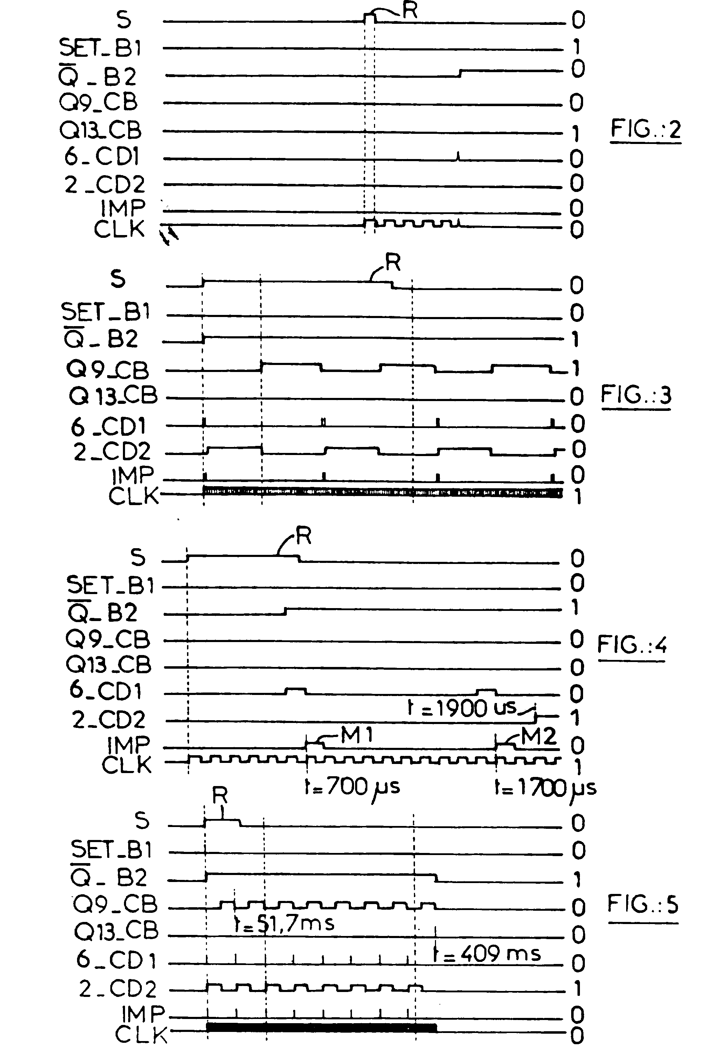

On se réfère aux chronogrammes des figures 3 et 5 où l'on a représenté sur la ligne IMP, la trame d'impulsions émises par le dispositif suivant l'invention. Sur la ligne IMP de la figure 3 il apparaît que cette trame est constituée de salves périodiques de deux impulsions. La trame compte un nombre prédéterminé de telles salves. A titre d'exemple, on a représenté sur la figure 5 une trame complète qui, sur la ligne IMP apparaît comme comptant huit salves. Sur la figure 5, les deux impulsions d'une même salve apparaissent confondues du fait de la compression de l'échelle de temps utilisée.

Comme on le verra dans la suite, la présente invention permet de choisir le nombre d'impulsions compris dans une salve. Dans l'application mentionnée ci-dessus au réveil d'un ensemble de modules électroniques embarqués dans un véhicule automobile, où au moins certains de ces modules sont équipés d'un dispositif suivant l'invention, le nombre d'impulsions contenues dans une salve permet à une unité centrale de traitement interconnectée avec ces modules, de détecter quel est le module émetteur de la trame. Dans ce cas, chaque module émetteur doit être associé à une trame dans laquelle les salves comptent un nombre particulier et prédéterminé d'impulsions. Comme on le verra dans la suite, le dispositif suivant l'invention comprend des moyens permettant de choisir simplement et de manière économique le nombre d'impulsions d'une salve émise par tel ou tel module.

Comme on l'a vu plus haut, chaque trame compte un nombre prédéterminé de salves. Comme on le verra dans la suite, les trames émises par le dispositif suivant l'invention comprennent huit salves. Bien entendu on pourrait choisir un autre nombre de salves pour chaque trame. On a choisi de répéter les salves au sein d'une trame pour assurer un nécessaire filtrage. En effet, des impulsions parasites peuvent être induites sur les lignes qui font communiquer le module émetteur et une unité centrale de traitement interconnectée avec ce module. Pour s'affranchir de ces impulsions parasites, l'unité centrale peut comparer le nombre d'impulsions contenues dans des salves successives et ne prendre en compte la trame d'impulsions émise que si des salves successives contiennent le même nombre d'impulsions.

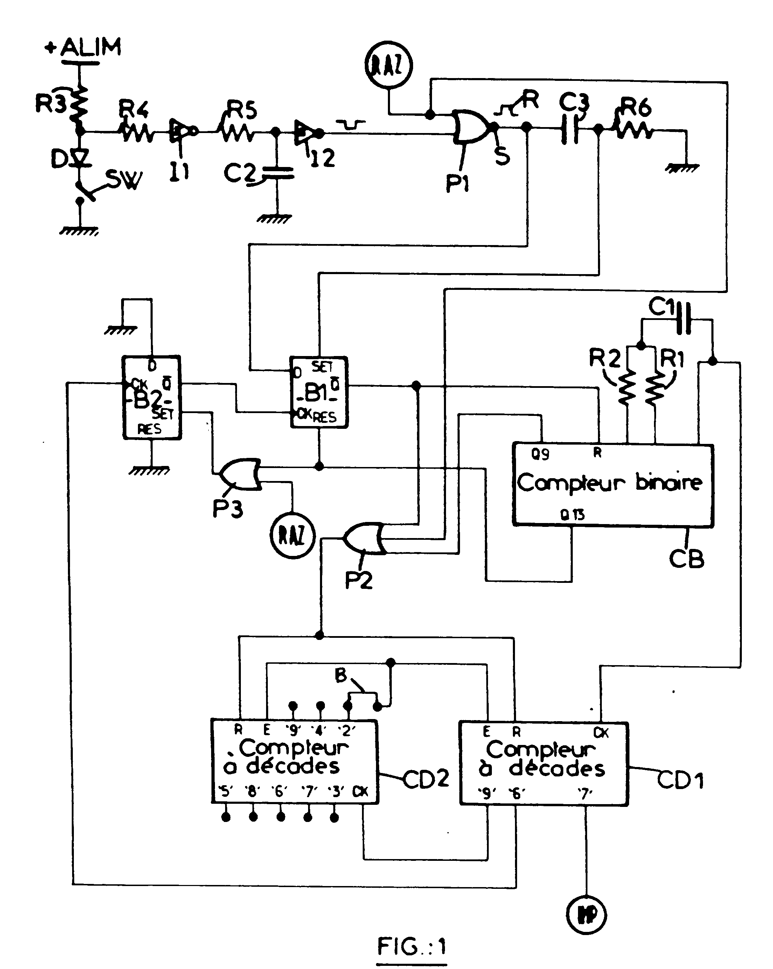

Ayant ainsi défini la trame d'impulsions que doit émettre le dispositif suivant l'invention, on se réfère maintenant à la figure 1 du dessin annexé pour procéder à une description de la structure de ce dispositif.

Celui-ci est construit essentiellement autour d'un compteur binaire CB et de premier et deuxième compteurs à décades CD1 et CD2 respectivement. A titre d'exemple, le compteur binaire CB peut être constitué par un circuit intégré CMOS type 4060, à quatorze étages. De même les compteurs à décades, dit aussi compteurs-décodeurs ou compteurs de Johnson à cinq étages, peuvent être constitués chacun par un circuit intégré CMOS type 4017.

Comme il est bien connu, le compteur binaire CB du type 4060 peut être associé à une horloge interne constituée par un oscillateur comprenant les résistances R1 et R2 et la capacité C1. La constante de temps du circuit R1, C1 fixe la fréquence de cet oscillateur et donc la fréquence d'horloge. Suivant une caractéristique du dispositif selon l'invention qui apparaît à la figure 1, l'horloge interne du compteur binaire CB alimente également l'entrée d'horloge CK du premier compteur à décades CD1. On notera que la sortie 9 de ce compteur à décades commande elle-même l'entrée d'horloge CK du deuxième compteur à décades CD2. La trame d'impulsions IMP engendrée par le dispositif selon l'invention, apparaît sur la sortie 7 du compteur à décades CD1. D'une manière générale, et comme on le verra en détail dans la suite, le compteur binaire CB commande la fréquence de répétition des salves d'impulsions ainsi que le nombre de salves comprises dans une même trame tandis que le compteur à décades CD2 fixe le nombre d'impulsions comprises dans une même salve. Le compteur à décades CD1 réagit à des signaux de commande issus du compteur binaire CB et du compteur à décades CD2 pour émettre sur sa sortie 7 une suite de $n$ salves périodiques de $m$ impulsions, le nombre $m$ étant fixé par le compteur à décades CD2 et le nombre $n$ étant fixé par le compteur binaire CB.

Le dispositif suivant l'invention comprend un moyen de formation d'un signal de déclenchement R de l'émission d'une trame d'impulsions, ce moyen étant constitué par un interrupteur SW à contact-travail, placé en série avec une diode de protection D1 et une résistance R3, entre une source d'énergie électrique +ALIM, constituée par exemple par la batterie d'un véhicule automobile, et la masse. Le point commun à la diode D1 et à la résistance R3 est connecté à un circuit de conformation d'impulsions (I1, I2, R5, C2) à travers une résistance R4. Un tel circuit est classique et il est formé de deux inverseurs I1, I2, d'une capacité C2 et d'une résistance R5 interposées entre les deux inverseurs. On peut prélever un tel circuit par exemple sur un circuit intégré CMOS du type 4000.

Le circuit de conformation assure classiquement la transmission d'une impulsion rectangulaire négative bien conformée et déparasitée à une entrée d'une porte logique NON-OU P1, à la fermeture de l'interrupteur SW. La porte P1 comporte une deuxième entrée connectée à une source d'un signal RAZ qui se trouve normalement à l'état bas quand le dispositif suivant l'invention est appelé à émettre une trame d'impulsions. Ainsi, le signal qui apparaît sur la sortie S de la porte P1 quand une impulsion rectangulaire est appliquée à son autre entrée prend la forme d'une impulsion rectangulaire inversée R.

Le dispositif suivant l'invention comprend encore des première (B1) et deuxième (B2) bascules type D qui peuvent être prélevées par exemple sur un circuit intégré CMOS du type 4013. On remarquera que la sortie S de la porte P1 est connectée à l'entrée D de la bascule B1 alors que l'entrée de forçage SET de cette même bascule est connectée au point commun à une capacité C3 et une résistance R6 placée en série entre la sortie 7 de la porte P1 et la masse. La sortie $\overline{Q}$ de la bascule B1 commande l'entrée R ou " RESET" du compteur binaire CB. Pour des raisons qui seront explicitées dans la suite, l'entrée de forçage RESET de la bascule B1 est connectée à la sortie Q13 du compteur binaire. On notera encore que l'entrée d'horloge CK de la bascule B1 est commandée par la sortie $\overline{Q}$ de la bascule B2. Comme on le verra dans la suite, la bascule B1 constitue l'organe principal de moyens de commande des entrées de remise à zéro des compteurs CB, CD1 et CD2.

En ce qui concerne la bascule B2 on notera que son entrée D et son entrée de forçage RESET sont toutes deux mises à la masse alors que son entrée d'horloge CK est commandée par l'étage de rang 6 du compteur à décades CD1, pour un but que l'on expliquera dans la suite de la présente description.

Deux portes OU, P2 et P3, complètent le dispositif suivant l'invention. La porte OU P2 compte trois entrées connectées respectivement à la sortie $\overline{Q}$ de la bascule B1, à la source RAZ et à la sortie Q9 du compteur binaire, la sortie de cette porte P2 commandant les entrées R ou RESET des compteurs à décades CD1 et CD2. La porte OU P3 comporte deux entrées connectées respectivement à la source RAZ et à la sortie Q13 du compteur binaire CB, la sortie de la porte P3 commandant l'entrée de forçage SET de la bascule B2.

On notera encore que la sortie de rang 2 du compteur à décades CD2 commande les entrées de validation E des compteurs à décades CD1 et CD2. Suivant une caractéristique du dispositif selon l'invention, un moyen de connexion amovible tel qu'une barrette B assure la liaison entre le sortie 2 du compteur à décades CD2 et les entrées de validation des deux compteurs à décades. Comme on le verra dans la suite, on pourrait utiliser une barrette telle que B pour établir une liaison entre ces entrées de validation et l'une quelconque des sorties 2 à 9 du compteur à décades, pour fixer le nombre d'impulsions contenues dans chaque salve de la trame d'impulsions qui apparaît sur la sortie 7 du compteur à décades CD1. On dispose ainsi d'un moyen simple et peu coûteux pour personnaliser le dispositif selon l'invention, suivant qu'il est implanté dans tel ou tel module électronique d'un ensemble de tels modules interconnectés. Le nombre d'impulsions par salve, détecté sur la sortie 7 du compteur à décades CD1, permet alors d'identifier le module émetteur de la trame d'impulsions.

On va maintenant procéder à la description du fonctionnement du dispositif suivant l'invention. Pour fixer les idées, et à titre d'exemple seulement, on se placera dans le cas où l'on souhaite émettre une trame d'impulsions durant chacune environ 100 µs et réparties en huit salves dont la fréquence de répétition est de 50 millisecondes environ. A l'intérieur d'une même salve, les impulsions se répètent avec une période de 1 ms environ. Dans l'exemple choisi, chaque salve compte deux impulsions.

Lorsqu'une fermeture de l'interrupteur SW provoque l'apparition à la sortie S de la porte P1 d'une impulsion R de déclenchement, le front montant de cette impulsion est appliqué sur l'entrée D de la bascule B1, alors que la tension présente au point commun à la capacité C3 et à la résistance R6, qui dérive de celle appliquée en R, est appliquée à l'entrée SET de la bascule B1 pour maintenir la sortie $\overline{Q}$ de cette bascule à zéro et déclencher le compteur binaire CB. La capacité C3 et la résistance R6 sont choisies pour assurer un maintien initial de la sortie $\overline{Q}$ de la bascule B1 à zéro pendant un intervalle de temps minimum nécessaire à l'amorçage du comptage, cet intervalle de temps pouvant être réglé à quelques µs par un choix approprié des valeurs de la résistance R6 et de la capacité C3.

Pour conformer le compteur binaire aux valeurs numériques des durées d'impulsions et des périodes indiquées plus haut à titre d'exemple, on règle l'oscillateur (C1, R1) de manière que l'horloge interne du compteur binaire émette un signal de fréquence N = 10kHz et donc d'une période de 100µs. On sait qu'alors un étage de sortie Qx du compteur binaire oscille à une fréquence $N/2^x$, x étant un nombre entier naturel.

Par ailleurs le compteur à décades CD1, également alimenté par ce signal d'horloge de fréquence N, compte les impulsions du signal d'horloge. Comme ce compteur est commandé sur front montant, chacune des sorties décodées "0" à "9" de ce compteur-décodeur va passer successivement à l'état haut pendant 100µs, ceci toutes les dix impulsions, comme il est bien connu. Ainsi sur la sortie "7" dispose-t-on d'impulsions d'une durée d'environ 100µs qui peuvent être répétées après 1 ms, conformément à la spécification donnée plus haut pour cette durée d'impulsions et la fréquence de leur répétition au sein d'une même salve.

On décrit dans la suite, à l'aide des chronogrammes des figures 2 à 5, comment le dispositif suivant l'invention séquence ces impulsions sur la sortie 7 du compteur décodeur CD1, suivant la trame de n salves de m impulsions définie ci-dessus et représentée aux lignes IMP des figures 3 et 5. Dans ces chronogrammes, on a représenté les signaux disponibles à la sortie S de la porte P1, sur l'entrée SET de la bascule B1, sur la sortie $\overline{Q}$ de la bascule B2, sur les sorties Q9 et Q13 du compteur binaire CB, sur les sorties "6" et "2" respectivement des compteurs à décades CD1 et CD2, sur la sortie 7 (IMP) du compteur CD1 et les signaux d'horloge CLK.

La première opération exécutée par le dispositif suivant l'invention est une opération de validation de l'impulsion R. En effet, dans l'environnement automobile mentionné plus haut, des impulsions parasites peuvent être induites dans les lignes du dispositif suivant l'invention. Il convient d'empêcher qu'une impulsion parasite induite sur la sortie de la porte P1 par exemple, ne provoque l'émission d'un train d'impulsions. Ces impulsions parasites sont ordinairement assez brèves et on convient que seule une impulsion R en sortie S de durée supérieure à une valeur prédéterminée, 600μs par exemple, doit être considérée comme significative de la fermeture de l'interrupteur SW, fermeture qui seule doit déclencher l'émission de la trame d'impulsions.

On se réfère à la figure 2 du dessin annexé pour expliquer ce qui se passe alors quand l'impulsion R est d'une durée inférieure à 600μs. Au front montant de cette impulsion R, l'horloge du compteur binaire commence à délivrer un signal CLK de période égale à 100μs, compte tenu de la fréquence d'horloge choisie de 10kHz. Ce signal d'horloge est appliqué à l'entrée CK du compteur à décades CD1 qui est commandé sur front montant. Ainsi les sorties décodées "0" à "9" du compteur à décades CD1 passent-elles successivement, toutes les 100μs, à l'état haut pour émettre une impulsion d'une durée d'environ 100μs. Ainsi la sortie 6 passe à l'état haut pendant 100μs au bout de 600μs. Cette sortie 6 commandant l'entrée d'horloge CK de la bascule B2 600 μs après le front montant de l'impulsion R, la sortie $\overline{Q}$ de la bascule B2 passe au niveau 1 pour échantillonner alors, par l'intermédiaire de l'entrée D de la bascule B1, la tension sur la sortie S de la porte P1. Si, comme représenté sur le chronogramme de la figure 2, l'impulsion R a alors disparu, un niveau logique 1 est transféré sur la sortie Q de la bascule B1 qui bloque le compteur binaire et donc le comptage des impulsions. Il s'ensuit qu'aucune impulsion n'apparaît sur la sortie 7 du compteur-décodeur CD1 alors qu'une telle impulsion aurait due apparaître normalement 700μs après le front montant de l'impulsion R. On comprend qu'ainsi une impulsion R de durée inférieure à 600μs est incapable de déclencher l'émission d'une trame d'impulsions par le dispositif selon l'invention. On comprend qu'en choisissant une sortie autre que "6" sur le compteur CD1, on pourrait ainsi filtrer des impulsions de durée inférieure à une durée prédéterminée différente de 600 μs. Ce compteur CD1 et les deux bascules (B1, B2) constituent ainsi des moyens d'échantillonnage de la durée de l'impulsion de déclenchement R.

Si au contraire l'impulsion R de déclenchement est d'une durée supérieure à 600μs, l'échantillonnage de la sortie S de la porte P1 par l'intermédiaire de l'entrée D de la bascule B1 fait apparaître un niveau logique 0 sur la sortie Q de la bascule B1 et le comptage d'impulsions peut alors se poursuivre (voir les chronogrammes des figures 3 à 5).

En référence au chronogramme de la figure 4, où l'échelle des temps a été fortement dilatée pour faire apparaître clairement toutes les impulsions alors émises, on voit qu'à l'instant t = 700μs, une première impulsion $M_1$ est émise sur la sortie 7 du compteur CD1 (ligne IMP). Il s'agit là de la première des deux impulsions ($M_1$, $M_2$) de la première salve de la trame d'impulsions à émettre. La sortie 9 du compteur CD1 bascule ensuite t = 900μs, pour envoyer une impulsion d'horloge au compteur à décades CD2 qui commence son comptage. La deuxième impulsion $M_2$ de la salve ($M_1$, $M_2$) apparaît à t = 1700μs sur la sortie 7 du compteur CD1 et, à t = 1900μs, la sortie 2 du compteur CD2 émet une impulsion qui agit sur les entrées de validation E des compteurs CD1 et CD2 de manière à bloquer leurs comptages. A ce moment le dispositif suivant l'invention a fini d'émettre la première salve de la trame et, conformément aux spécifications données ci-dessus à titre d'exemple, une deuxième salve doit lui succéder 50 millisecondes plus tard environ.

Pour ce faire on utilise la sortie Q9 du compteur binaire dont la fréquence de basculement, de l'état haut à l'état bas par exemple, est justement égale à celle du signal d'horloge à 10kHz, divisé par $2^9$, soit 19 Hz, ce qui correspond à une période de 51,7 millisecondes. La porte OU P2 commande les entrées de remise à zéro R des compteurs à décades CD1 et CD2. Ainsi, lorsque la sortie Q9 du compteur binaire passe à l'état logique 1, la porte OU P2 commande la remise à zéro des compteurs à décades CD1 et CD2 qui reprennent alors leurs comptages comme décrit précédemment pour émettre une deuxième salve d'impulsions puis une troisième salve etc...celles-ci se répétant avec une période de 51,7 millisecondes.

Conformément aux spécifications énoncées plus haut, le nombre des salves à répéter doit être limité à 8. On utilise pour cela le signal émis sur la sortie Q13 du compteur binaire, qui bascule avec une fréquence égale à la fréquence de base de 10kHz divisée par $2^{13}$, soit une fréquence de 1,22 Hz correspondant à une période de 819 millisecondes. Au bout d'une demi-période, soit 409 millisecondes, la sortie Q13 du compteur binaire passe à l'état logique 1 et cet état logique s'impose sur l'entrée de forçage RESET de la bascule B1, la sortie $\overline{Q}$ basculant alors à l'état logique 1. Le niveau 1 installé sur la sortie $\overline{Q}$ de la bascule B1 alimente l'entrée R du compteur binaire dont le comptage se bloque pour empêcher la génération d'impulsions supplémentaires (voir figure 5). En effet, la demi-période de 409 ms du signal issu de la sortie Q13 du compteur binaire étant comprise entre (n-1) fois et $\underline{n}$ fois (avec n = 8) la période de répétition des salves (51,7 ms), on comprend que la génération de la (n+1)ème salve est empêchée par le passage, à t = 409 ms, de la sortie Q13 du compteur binaire au niveau 1.

La trame d'impulsions constituée de $\underline{n}$ salves ($\underline{n}$ = 8) de $\underline{m}$ impulsions ($\underline{m}$ = 2) est maintenant entièrement passée sur la ligne connectée à la sortie 7 du compteur CD1, pour être ensuite détectée et éventuellement filtrée par des circuits spécialisés, avant d'être transmise à des moyens de traitement de données propres à exploiter l'information ainsi reçue. Comme on l'a vu plus haut à titre d'exemple, ces moyens peuvent servir à "réveiller" un ensemble de modules électroniques qui se trouvaient auparavant en état de veille, comme décrit dans la demande de brevet précitée. Cet état de veille est d'ailleurs caractérisé par la présence d'un état logique 0 sur les entrées RAZ des portes P1 et P3, qui passent alors à cet état logique lorsque tous les modules électroniques passent d'un état de fonctionnement normal à un état de veille. Ainsi, en fonctionnement normal (RAZ = 1) la sortie de la porte NON-OU P1 est bloquée à l'état 0 et l'émission d'une trame d'impulsions est impossible. De même l'entrée SET de la bascule B1 est alors bloquée à l'état 0 (tension nulle au point commun à C3 et R6) et donc la sortie $\overline{Q}$ de cette bascule est bloquée à l'état 1 ce qui provoque le blocage du compteur binaire jusqu'à un éventuel déblocage ultérieur par le front montant d'une impulsion de déclenchement R de durée convenable.

Bien entendu l'invention n'est pas limitée au mode de réalisation décrit et représenté qui n'a été donné qu'à titre d'exemple. En particulier, on ne sortirait pas du cadre de l'invention en choisissant autrement les entrées et sorties actives des compteurs utilisés, par exemple pour autoriser la production par le dispositif suivant l'invention d'une trame d'impulsions comptant d'autres nombres de salves ou d'impulsions dans une salve, avec des périodicités et des durées d'impulsions différentes.

## Revendications

1. Dispositif de génération d'une trame d'impulsions électriques constituée de $\underline{n}$ salves de $\underline{m}$ impulsions, ces salves se répétant avec une période T prédéterminée, caractérisé en ce qu'il comprend :

   a) un compteur binaire (CB);
   b) un premier compteur à décades (CD1);
   c) un générateur de signaux d'horloge pour alimenter simultanément ces deux compteurs;
   d) un deuxième compteur à décades (CD2) dont l'entrée d'horloge est connectée à une sortie prédéterminée (9) du premier compteur à décades (CD1);
   e) un moyen de formation d'un signal de déclenchement (R) de ces compteurs et du générateur de signaux d'horloge;

   la sortie de rang $\underline{m}$ du deuxième compteur à décades (CD2) commandant des entrées de validation (E) des premier et deuxième compteurs à décades (CD1, CD2);
   une sortie prédéterminée (Q9) du compteur binaire (CB) délivrant un signal à la fréquence 1/T de répétition des salves commandant des entrées de remise à zéro des premier (CD1) et deuxième (CD2) compteurs à décades,
une autre sortie prédéterminée (Q13) du compteur binaire (CB) délivrant un signal présentant une demi-période comprise entre (n-1)T et nT, commandant le blocage du compteur binaire (CB),
ce par quoi une trame de $\underline{n}$ salves de $\underline{m}$ impulsions apparaît sur une sortie (7) du premier compteur à décades (CD1), à la suite de l'émission du signal de déclenchement (R).

2. Dispositif conforme à la revendication 1, caractérisé en ce qu'il comprend des moyens de commande (B1) des entrées de remise à zéro des compteurs (CB, CD1, CD2) et des moyens (CD1, B2, B1) pour échantillonner la durée du signal de déclenchement (R), ces moyens d'échantillonnage commandant le blocage du compteur binaire (CB1) quand la durée du signal de déclenchement (R) est inférieure à une durée prédéterminée.

3. Dispositif conforme à la revendication 2, caractérisé en ce que les moyens de commande sont constitués par une première bascule (B1) type D et en ce que les moyens pour échantillonner la durée du signal de déclenchement comprennent une deuxième bascule (B2) type D commandant l'entrée d'horloge de la première bascule (B1) dont l'entrée (D) est commandée par le signal de déclenchement, l'entrée d'horloge de la deuxième bascule (B2) étant commandée par une sortie (6) du premier compteur à décades (CD1) qui émet une impulsion sur l'entrée d'horloge de la deuxième bascule (B2) au bout d'un temps égal à la durée prédéterminée minimum du signal de déclenchement (R) nécessaire à la prise en compte de celui-ci.

4. Dispositif conforme à la revendication 3, caractérisé en ce qu'il comprend un circuit de conformation (I1, I2, R5, C2) du signal de déclenchement en une impulsion rectangulaire (R) délivrée à la sortie d'une porte NON-OU (P1) à deux entrées dont l'autre est connectée à une source d'un signal (RAZ) de remise à zéro du dispositif.

5. Dispositif conforme à la revendication 4, caractérisé en ce que la sortie de la porte NON-OU (P1) est traitée dans un circuit (C3, R6) de génération d'un signal de commande de l'entrée de forçage (SET) de la première bascule (B1) pour commander le démarrage du compteur binaire (CB) à l'apparition du signal de déclenchement (R) à la sortie de la porte (P1).

6. Dispositif conforme à l'une quelconque des revendications 4 et 5, caractérisé en ce qu'il comprend une porte OU (P2) pour commander les entrées de remise à zéro des premier et deuxième compteurs à décades (CD1, CD2), les entrées de cette porte étant connectées respectivement à la source du signal de remise à zéro (RAZ), à la sortie ($\bar{Q}$) de la première bascule (B1) et à la sortie (Q9) du compteur binaire (CB).

7. Dispositif conforme à l'une quelconque des revendications 3 à 6, caractérisé en ce qu'il comprend une porte OU (P3) pour commander l'entrée de forçage (SET) de la deuxième bascule (82), les entrées de cette porte (P3) étant connectées respectivement à la source du signal de remise à zéro (RAZ) et à la sortie (Q13) du compteur binaire (CB) pour commander, à travers la première bascule (B1) la remise à zéro du compteur binaire (CB).

8. Dispositif conforme à l'une quelconque des revendications précédentes, caractérisé en ce que la source du signal d'horloge est intégrée au compteur binaire (CB).

9. Dispositif conforme à l'une quelconque des revendications précédentes, caractérisé en ce qu'il comprend des moyens de connexion (B) pour sélectionner la sortie de rang $\underline{m}$ du deuxième compteur à décades qui commande les entrées (E) de validation des compteurs à décades (CD1, CD2).

10. Application du dispositif conforme à l'une quelconque des revendications 1 à 9, la génération d'impulsions de réveil d'un ensemble de modules électroniques embarqués dans un véhicule automobile.

**Patentansprüche**

1. Vorrichtung zum Erzeugen eines Rahmens aus elektrischen Impulsen, der aus $\underline{n}$ Folgen von $\underline{m}$ Impulsen besteht, wobei die Folgen sich mit einer vorgegebenen Periode T wiederholen, dadurch gekennzeichnet, daß sie aufweist:

a) einen Binärzähler (CB);
b) einen ersten Dekadenzähler (CD1);
c) einen Zeitsignalgenerator zur gleichzeitigen Speisung dieser beiden Zähler;
d) einen zweiten Dekadenzähler (CD2), dessen Zeiteingang mit einem vorgegebenen Ausgang (9) des ersten Dekadenzählers (CD1) verbunden ist;
e) eine Anordnung zur Bildung eines Auslösesignals (R) für diese Zähler und den Zeitsignalgenerator;

wobei der Ausgang mit dem Rang $\underline{m}$ des

zweiten Dekadenzählers (CD2) die Aktivierungseingänge (E) des ersten und des zweiten Dekadenzählers (CD1, CD2) steuert, und

wobei ein vorgegebener Ausgang (Q9) das Binärzählers (CB) ein Signal mit der Wiederholfrequenz (1/T) für die Folgen abgibt, welches die Eingänge zur Rückstellung auf Null des ersten und zweiten Dekadenzählers (CD1) und (CD2) steuert, und

wobei ein anderer vorgegebener Ausgang (Q13) des Binärzählers (CB) ein Signal abgibt, welches eine Halbperiode aufweist, die zwischen (n-1)T und nT liegt und die Blockierung des Binärzählers (CB) steuert, so daß ein Rahmen von $\underline{n}$ Folgen von $\underline{m}$ Impulsen am Ausgang des ersten Dekadenzählers (CD1) erscheint, als Folge der Abgabe des Auslösesignals (R).

2. Vorrichtung nach Anspruch 1, dadurch gekennzeichnet, daß sie eine Steueranordnung (B1) für die Eingänge zur Rückstellung auf Null der Zähler (CB, CD1, CD2) und eine Anordnung (CD1, B2, B1) aufweist, zur Momentanwertbildung der Dauer des Auslösesignals (R), wobei die Anordnung zur Momentanwertbildung die Blockierung des Binärzählers (CB1) steuert, wenn die Dauer des Auslösesignals (R) kleiner als eine vorgegebene Dauer ist.

3. Vorrichtung nach Anspruch 2, dadurch gekennzeichnet, daß die Steueranordnung aus einer ersten Kippschaltung (B1) vom Typ D besteht und daß die Anordnung zur Momentanwertbildung der Dauer des Auslösesignals eine zweite Kippschaltung (B2) vom Typ D aufweist, welche den Zeiteingang der ersten Kippschaltung (B1) steuert, dessen Eingang (D) vom Auslösesignal gesteuert wird, während der Zeiteingang der zweiten Kippschaltung (B2) von einem Ausgang (6) des ersten Dekadenzählers (CD1) gesteuert wird, welcher einen Impuls dem Zeiteingang der zweiten Kippschaltung (B2) am Ende einer Zeit zuführt, die gleich der vorgegebenen Minimaldauer des Auslösesignals und zu dessen Berücksichtigung erforderlich ist.

4. Vorrichtung nach Anspruch 3, dadurch gekennzeichnet, daß sie eine Schaltung zur Umformung (I1, I2, R5, C2) des Auslösesignals in einen rechtwinkligen Impuls (R) aufweist, welcher am Ausgang einer NEIN-ODER-Torschaltung (P1) mit zwei Eingängen ansteht, dessen anderer mit einer Signalquelle (RAZ) zur Rückstellung auf Null der Vorrichtung verbunden ist.

5. Vorrichtung nach Anspruch 4, dadurch gekennzeichnet, daß das Ausgangssignal der NEIN-ODER-Torschaltung (P1) in einem Schaltkreis (C3, R6) zur Erzeugung eines Steuersignals für den Setzeingang (SET) der ersten Kippschaltung (B1) verarbeitet wird, um die Auslösung des Binärzählers (CP) zu steuern bei Erscheinen des Auslösesignals (R) am Ausgang der Torschaltung (P1).

6. Vorrichtung nach einem der Ansprüche 4 und 5, dadurch gekennzeichnet, daß sie eine ODER-Torschaltung (P2) aufweist, zur Steuerung der Eingänge für die Rückstellung auf Null des ersten und des zweiten Dekadenzählers (CD1, CD2), wobei die Eingänge dieser Torschaltung mit der Signalquelle für die Rückstellung auf Null (RAZ) bzw. mit dem Ausgang (Q) der ersten Kippschaltung (B1) und dem Ausgang (Q9) des Binärzählers (CB) verbunden sind.

7. Vorrichtung nach einem der Ansprüche 3 bis 6, dadurch gekennzeichnet, daß sie eine ODER-Torschaltung (P3) aufweist zur Steuerung des Setzeingangs (SET) der zweiten Kippschaltung (B2), wobei die Eingänge dieser Torschaltung (P3) mit der Signalquelle für die Rückstellung auf Null (RAZ) bzw. mit dem Ausgang (Q13) des Binärzählers (CB) verbunden sind, um mit Hilfe der ersten Kippschaltung (B1) die Rückstellung auf Null des Binärzählers (CB) zu steuern.

8. Vorrichtung nach einem der vorhergehenden Ansprüche, dadurch gekennzeichnet, daß die Zeitsignalquelle in den Binärzähler (CB) integriert ist.

9. Vorrichtung nach einem der vorhergehenden Ansprüche, dadurch gekennzeichnet, daß sie eine Verbindungsanordnung (B) aufweist, um den Ausgang mit dem Rang m des zweiten Dekadenzählers auszuwählen, welcher die Aktivierungseingänge (E) der Dekadenzähler (CD1, CD2) steuert.

10. Anwendung der Vorrichtung nach einem der Ansprüche 1 bis 9 auf die Erzeugung von Einschaltimpulsen für eine Anzahl von in einem Kraftfahrzeug eingebauten, elektronischen Modulen.

**Claims**

1. An apparatus for generating a frame of electrical pulses formed by n salvoes of m pulses, said salvoes being repeated with a predetermined period T, characterised in that it comprises:

   a) a binary counter (CB):
   b) a first decade counter (CD1);
   c) a clock signal generator for simultaneously supplying said two counters;
   d) a second decade counter (CD2) whose clock input is connected to a predetermined output (9) of the first decade counter (CD1);
   e) a means for forming a triggering signal (R) for said counters and the clock signal generator;

   the line m output of the second decade counter (CD2) controlling validation inputs (E) of the first and second decade counters (CD1, CD2);
   a predetermined output (Q9) of the binary counter (CB) delivering a signal at a frequency 1/T of repetition of the salvoes controlling zero-resetting inputs of the first and second decade counters (CD1; CD2),
   and another predetermined output (Q13) of the binary counter (CB) delivering a signal having a half-period of between (n-1)T and nT, controlling blocking of the binary counter (CB),
   whereby a frame of n salvoes of m pulses appears at an output (7) of the first decade counter (CD1) following the emission of the triggering signal (R).

2. An apparatus according to claim 1 characterised in that it comprises control means (B1) for the zero-resetting inputs of the counters (CB, CD1, CD2) and means (CD1, B2, B1) for sampling the duration of the triggering signal (R), said sampling means controlling blocking of the binary counter (CB1) when the duration of the triggering signal (R) is less than a predetermined duration.

3. An apparatus according to claim 2 characterised in that the control means are formed by a first D-type flip-flop (B1) and that the means for sampling the duration of the triggering signal comprise a second D-type flip-flop (B2) for controlling the clock input of the first flip-flop (B1) whose input (D) is controlled by the triggering signal, the clock input of the second flip-flop (B2) being controlled by an output (6) of the first decade counter (CD1) which emits a pulse on the clock input of the second flip-flop (B2) at the end of a time equal to the predetermined minimum duration of the triggering signal (R) which is necessary for taking sane into account.

4. An apparatus according to claim 3 characterised in that it comprises a circuit (I1, I2, R5, C2) for shaping the triggering signal as a rectangular pulse (R) delivered at the output of a NOR-gate (P1) having two inputs, the other of which is connected to a source of a zero-resetting signal (RAZ) of the apparatus.

5. An apparatus according to claim 4 characterised in that the output of the NOR-gate (P1) is processed in a circuit (C3, R6) for generating a signal for controlling the forcing input (SET) of the first flip-flop (B1) to control starting of the binary counter (CB) upon the appearance of the triggering signal (R) at the output of the gate (P1).

6. An apparatus according to either one of claims 4 and 5 characterised in that it comprises an OR-gate (P2) for controlling the zero-resetting inputs of the first and second decade counters (CD1, CD2), the inputs of said gate being respectively connected to the zero-resetting signal source (RAZ), to the output ($\overline{Q}$) of the first flip-flop (B1) and to the output (Q9) of the binary counter (CB).

7. An apparatus according to any one of claims 3 to 6 characterised in that it comprises an OR-gate (P3) for controlling the forcing input (SET) of the second flip-flop (B2), the inputs of said gate (P3) being respectively connected to the zero-resetting signal source (RAZ) and to the output (Q13) of the binary counter (CB) to oontrol by way of the first flip-flop (B1) resetting to zero of the binary counter (CB).

8. An apparatus according to any one of the preceding claims characterised in that the clock signal source is integrated in the binary counter (CB).

9. An apparatus according to any one of the preceding claims characterised in that it comprises connecting means (B) for selecting the line m output of the second decade counter which controls the validation inputs (E) of the decade counters (CD1, CD2).

10. Use of the apparatus according to any one of claims 1 to 9 for generating arming pulses for an assembly of electronic modules which are installed in a motor vehicle.

FIG.:1

FIG.:2

FIG.:3

FIG.:4

FIG.:5